# EUROPÄISCHE PATENTSCHRIFT

(11) **EP 2 993 358 B1**
(45) Veröffentlichungstag und Bekanntmachung des Hinweises auf die Patenterteilung: **05.08.2020**
(21) Anmeldenummer: 15169527.7
(22) Anmeldetag: 28.05.2015
(51) Int. Cl.: F04D 29/58, H02K 11/00

(54) **LUEFTER MIT LEITERPLATTENKUEHLKREISLAUF**
VENTILATOR WITH CONDUCTOR PLATE COOLING CIRCUIT
VENTILATEUR DOTÉ D'UN CIRCUIT DE REFROIDISSEMENT DE CIRCUIT IMPRIMÉ

(30) Priorität: 05.09.2014 DE 102014112821
(43) Veröffentlichungstag der Anmeldung: 09.03.2016
(73) Patentinhaber: ebm-papst Mulfingen GmbH & Co. KG, 74673 Mulfingen (DE)
(72) Erfinder: STURM, Michael, 97980 Bad Mergentheim-Rot (DE); ECCARIUS, Michael Dr., 74673 Mulfingen-Jagstberg (DE)
(74) Vertreter: Staeger & Sperling Partnerschaftsgesellschaft mbB

(56) Entgegenhaltungen:
- DE-A1- 10 313 273
- DE-A1-102012 106 605
- US-A1- 2011 079 374

## Beschreibung

Die Erfindung betrifft einen Lüfter, insbesondere Radiallüfter, mit Leiterplattenkühlkreislauf zur Kühlung der auf der Leiterplatte verbauten Elektronikbauteile.

Aus dem Stand der Technik ist seit langem bekannt, dass zur Verlängerung der Lebensdauer und verbesserten Leistungsausnutzung der Elektronikbauteile auf einer Leiterplatte deren Kühlung sinnvoll ist. Dies wird beispielsweise in der DE 20 2005 004 274 U1 beschrieben. Bei der offenbarten Lösung profitiert man davon, dass Luft von außen über den Einströmbereich zur Leiterplatte führbar und diese damit kühlbar ist. Die im Stand der Technik bisher verwendeten Leiterplatten sind eben und weisen keine Öffnungen oder fertigungstechnisch unbestimmt positionierte Öffnungen beispielsweise zur Festlegung an dem Gehäuse oder anderen Bauteilen auf.

Weiterer bekannter Stand der Technik im vorliegenden technischen Gebiet ist offenbart in der Druckschrift DE 103 13 273 A1.

Besonders problematisch und Aufgabe der vorliegenden Erfindung ist jedoch, eine definierte Kühlung der Leiterplattenelektronikbauteile in einem geschlossenen dichten Elektronikgehäuse bereitzustellen, bei dem kein Austausch mit Umgebungsluft durch Abluft bzw. Zuluft nach/von außen möglich ist. Derartige abgedichtet geschlossene Gehäuse werden beispielsweise bei Lüftern nach IP-Schutzart (IPX4/IPX5 oder höher) eingesetzt.

Diese Aufgabe wird durch die Vorrichtung und das Verfahren gemäß den Merkmalskombinationen der Patentansprüche 1 und 12 gelöst.

Erfindungsgemäß wird ein Lüfter gemäß Anspruch 1 vorgeschlagen.

Beim Ansaugen der Luft mittels des Kühlrads durch die mindestens eine Zentralöffnung der Leiterplatte entsteht im Oberbereich des Elektronikgehäuses ein Unterdruck. Hierdurch wird aufgrund der dichten Ausbildung des Elektronikgehauses eine Luftrückströmung aus dem Unterbereich in den Oberbereich veranlasst, die über die Umfangsrandöffnungen oder Umfangsrandaussparungen ermöglicht wird. Es entsteht ein definierter geschlossener Luftkreislauf von dem auf die mindestens eine Zentralöffnung saugend wirkenden Kühlrad im Unterbereich radial auswärts entlang dem Elektronikgehäuse und anschließend über die Umfangsrandöffnungen oder Umfangsrandaussparungen der Leiterplatte zurück in den Oberbereich radial einwärts entlang der Oberfläche der Leiterplatte im Oberbereich und wieder zur mittigen, mindestens einen Zentralöffnung. Während der Strömung entlang dem Elektronikgehäuse gibt die Luft Wärme an das Gehäuse und mithin an die Umwelt ab.

Über diese Zirkulation der Luft entsteht ein Kühlluftkröislauf, der gegenüber einem direkten Anblasen der Elektronikbauteile mit ungekühlter Luft zu einer deutlich besseren und effizienteren Kühlung der elektronischen Bauteile und somit der integrierten Elektronik führt.

Als Umfangsrandöffnungen sind Öffnungen in der Leiterplatte in deren radialem Außenkantenbereich bestimmt. Als Umfangsrandaussparungen werden Aussparungen am radialen Rand der Leiterplatte definiert. Das vorliegend als Elektronikgehäuse bezeichnete Gehäuse nimmt zumindest die Elektronikbauteile des Lüfters auf, kann jedoch auch Teile weiterer Gehäuseteile wie beispielsweise das Gebläseradgehäuse oder Motorgehäuse umfassen, die zumeist ineinander übergehen oder durch ein Bauteil gebildet werden.

In einer vorteilhaften Ausführung werden Umfangsrandöffnungen oder Umfangsrandaussparungen an Positionen der Leiterplatte bestimmt, die radial auswärts von besonders heiß werdenden Elektronikbauteilen (Hotspots) liegen, so dass die Luftströmung von den Umfangsrandöffnungen oder Umfangsrandaussparungen radial einwärts an den Hotspots vorbeistreicht und diese besonders stark kühlt. Zur Erfindung gehört jedoch auch eine Ausführung, bei der Umfangsrandöffnungen und/oder Umfangsrandaussparungen über den gesamten radialen Randbereich der Leiterplatte bestimmt sind.

In einem Ausführungsbeispiel des erfindungsgemäßen Lüfters ist zwischen dem Elektronikgehäuse und dem radialen Rand der Leiterplatte ein Luftspalt vorgesehen, so dass auch eine vollständige Umströmung des radialen Rands der Leiterplatte von dem Unterbereich in den Oberbereich ermöglicht ist.

Die Kühlleistung kann durch verschiedene Maßnahmen verstärkt werden. Dabei sind sowohl Maßnahmen zur Strömungsoptimierung und Maßnahmen zur Verbesserung der Wärmeabfuhr vorteilhaft.

In einer günstigen Ausführung der Erfindung ist vorgesehen, dass das Kühlrad drehrichtungsorientierte gekrümmte Schaufeln aufweist, welche die Kühlströmung der Luft verstärken und den Kühlungseffekt an den Elektronikbauteilen, insbesondere bei höheren Drehzahlen, messbar erhöhen. Dabei kann es sich sowohl um eine Vorwärts- als auch um eine Rückwärtskrümmung der Schaufeln handeln, je nachdem in welcher Richtung das Kühlrad im Einsatz hauptsächlich rotiert.

Zur Erhöhung der Wärmeabgabe aus der durch das Kühlrad axial angesaugten und radial ausgeblasenen Luftströmung ist in einer vorteilhaften Ausführungsform der Erfindung vorgesehen, dass an der Innenwand des Elektronikgehäuses stoffschlüssig Kühlrippen ausgebildet sind, an denen die in radialer Richtung ausgeblasene Luft vorbeiströmt und Wärme über das Elektronikgehäuse abgibt. In einer besonders günstigen Ausführung erstrecken sich Kühlrippen dabei in radialer Richtung mit einer Krümmung, d.h. in einer Draufsicht bogenförmig. Die höchsten Strömungsgeschwindigkeiten und somit die größte Kühlwirkung wird ferner dann erreicht, wenn die Krümmung der Kühlrippen entgegen zu einer Krümmung der Schaufeln des Kühlrads gerichtet ist, so dass die Schaufeln und Kühlrippen in einer Draufsicht eine S-Form oder inverse S-Form bilden, je nachdem in welche Richtung das Kühlrad rotieren soll. Die Luftströmung wird dabei im radialen, sich an das Kühlrad anschließenden Bereich entlang der Kühlrippen radial auswärts bis zu den Umfangsrandöffnungen bzw. Umfangsrandaussparungen der Leiterplatte mit hohem Strömungsdruck geführt, so dass eine möglichst große Wärmeabgabe an das Elektronikgehäuse erfolgen kann und der in den Oberbereich zurückgeführte Luftstrom deutlich abgekühlt ist.

Als weitere Strömungsoptimierung ist der Lüfter erfindungsgemäß dadurch gekennzeichnet, dass das Kühlrad einen durch seine Nabe gebildeten, kegelförmigen Ansaugbereich aufweist. Der Ansaugbereich kann dabei durch die Nabenform des Kühlrads bestimmt werden. Ferner ist vorteilhaft, wenn an der mindestens einen Zentralöffnung der Leiterplatte eine zum Kühlrad gerichtete Einlassdüse ausgebildet oder als zusätzliches Bauteil angeordnet ist. In einer Ausführungsform wird die Einlassdüse durch eine zwischen dem Kühlrad und der Leiterplatte angeordnete Berührschutzvorrichtung zum Schutz der Leiterplatte bereit gestellt, die verhindert, dass elektrostatisch erzeugte Spannungen auf die Elektronik gelangen und diese beschädigen. Die Berührschutzvorrichtung weist dabei vorteilhafterweise eine zu der mindestens einen Zentralöffnung axial fluchtende Öffnung auf, an der die zu dem Kühlrad gerichtete Einlassdüse ausgebildet ist. Unabhängig davon, wo oder durch welches Bauteil die Einlassdüse gebildet wird, ist das Kühlrad erfindungsgemäß so ausgeführt und angeordnet, dass der kegelförmige Ansaugbereich des Kühlrads axial in die Einlassdüse hineinragt. Hierdurch können im Ansaugbereich des Kühlrads nach dem Düse-/ Diffusorprinzip höhere Strömungsgeschwindigkeiten oder Volumenströme erzielt und der dynamische Druck (Staudruck) an den Umfangsrandöffnungen bzw. Umfangsrandaussparungen der Leiterplatte vergrößert werden. Dabei sinkt der Unterdruck im Oberbereich des Elektronikgehäuses noch weiter ab und der Überdruck im Unterbereich steigt. Je größer der Druckunterschied zwischen Oberbereich und Unterbereich ist, desto mehr Wärme wird an das Elektronikgehäuse und dessen Kühlrippen abgegeben und desto stärker ist die Kühlleistung.

Bevorzugt ist eine Ausführung der Leiterplatte des Lüfters, bei der eine Fläche der mindestens einen Zentralöffnung um das 5- bis 50-fache, weiter bevorzugt das 10- bis 30-fache größer ist als eine Fläche einer Umfangsrandöffnung oder Umfangsrandaussparung, um eine ausreichend hohe Absaugung bei hohen Strömungsgeschwindigkeiten durch die Umfangsrandöffnungen bzw. Umfangsrandaussparungen der Leiterplatte zu erzielen.

Die Erfindung umfasst ferner Ausführungen, bei denen eine Vielzahl von Zentralöffnungen vorgesehen sind, die jeweils eine Fläche aufweisen, die im Wesentlichen einer Fläche der Umfangsrandöffnung oder Umfangsrandaussparung entspricht. Die Öffnungen können somit alle mit demselben Werkzeug erzeugt werden.

In einer Ausführung der Erfindung weist der Lüfter ferner eine über einen Motor antreibbare Antriebswelle mit daran angeordneten Lüfterrad auf, wobei zusätzlich auch das Kühlrad auf der Antriebswelle, insbesondere in einem axialen Endabschnitt der Antriebswelle, befestigt ist.

Das Kühlrad kann akustisch sowie aerodynamisch noch verbessert werden, indem im Bereich der Schaufeln eine Deckscheibe vorgesehen wird.

Die Erfindung betrifft auch das Verfahren zur Kühlung von auf der Leiterplatte des Lüfters angeordneten Elektronikbauteilen mit den Merkmalen des Anspruchs 12.

Im Übrigen sind alle für den Lüfter verfahrenstechnisch oben dargelegten Merkmale in das erfindungsgemäße Verfahren integrierbar, ohne dass diese als Verfahrensschritte nochmals wiederholt werden.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine seitliche, teilweise geschnittene Ansicht einer Ausführung eines Lüfters, der kein Teil der Erfindung ist;
- Fig. 2: eine Ausschnitt X aus Figur 1;
- Fig. 3: eine Ausführung gemäß der Erfindung in einer Teilschnittansicht;
- Fig. 4: eine weitere Ausführung gemäß der Erfindung in einer Teilschnittansicht;
- Fig. 5: eine perspektivische Ansicht einer Leiterplatte;
- Fig. 6: zwei Ausführungsformen von Kühlrädern; und
- Fig. 7: eine perspektivische Ansicht eines Lüfters mit zusätzlicher Teilvergrößerungsansicht.

Die Figuren sind beispielhaft schematisch und dienen zum besseren Verständnis von Ausführungsbeispielen der Erfindung. Gleiche Bezugszeichen benennen gleiche Teile in allen Ansichten.

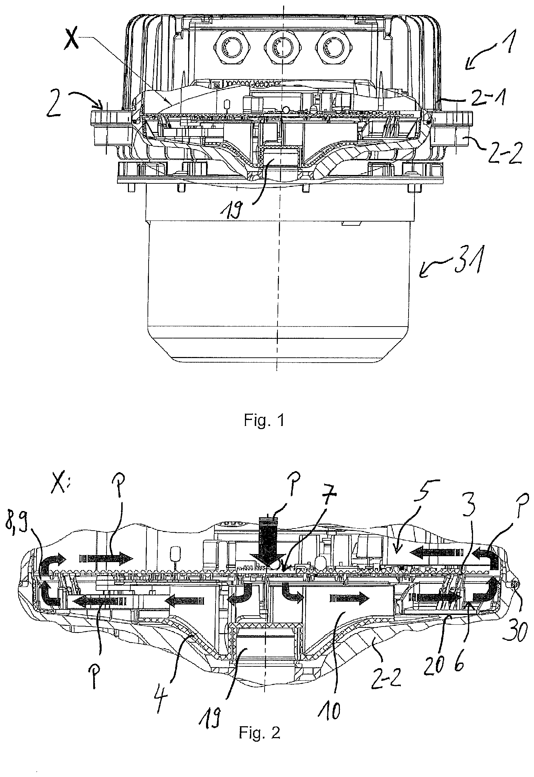

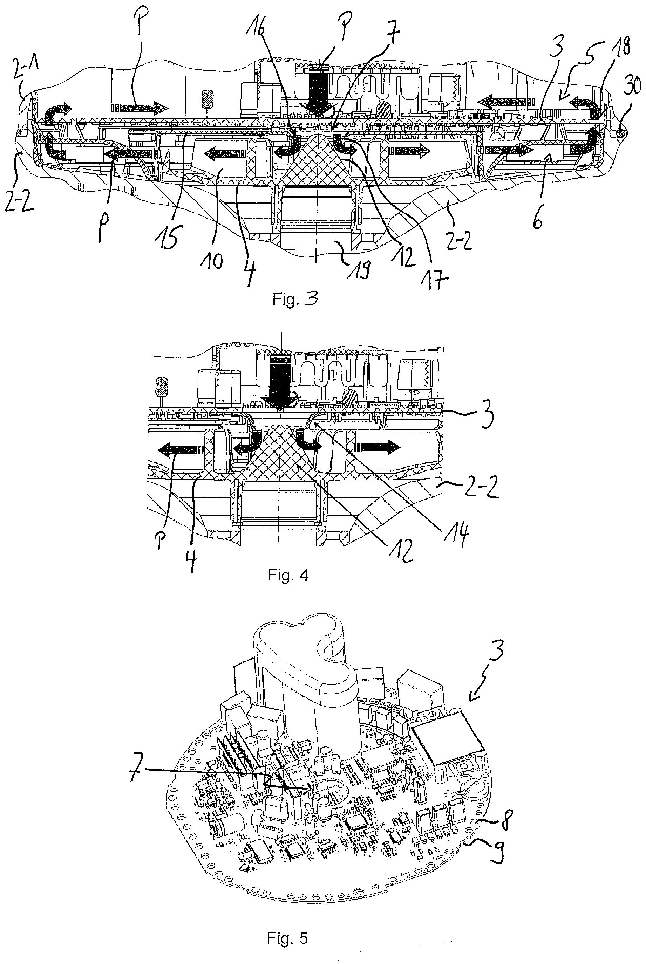

In Figur 1 ist ein Lüfter 1 in einer seitlichen, teilweise geschnittenen Ansicht dargestellt. Figur 2 zeigte den mit X gekennzeichneten geschnittenen Ausschnitt detaillierter und vergrößert. Der Lüfter 1 umfasst einen in einem Motorgehäuse 31 aufgenommenen Motor, der über eine Antriebswelle 19 ein Lüfterrad (nicht dargestellt) und ein Kühlrad 4 rotatorisch antreibt. In einem aus einem Untergehäuse 2-2 und einem Gehäusedeckel 2-1 gebildeten und gegenüber der Umwelt über die Dichtung 30 dichtend abgeschlossenen Elektronikgehäuse 2 ist eine Leiterplatte 3 mit verschiedenen Elektronikbauteilen angeordnet, die das Elektronikgehäuse 2 in einen Oberbereich 5 und einen Unterbereich 6 unterteilt. Der Unterbereich 6 ist dabei bestimmt als der auf der Seite des Kühlrads 4 liegende Bereich, der Oberbereich 5 als der auf der dem Kühlrad 4 gegenüberliegenden Seite der Leiterplatte 3 liegende Bereich. Die Leiterplatte 3 weist mittig eine Zentralöffnung 7 auf, durch welche der Oberbereich 5 mit dem Unterbereich 6 strömungsverbunden ist, so dass über eine Drehung des Kühlrads 4, Luft aus dem Oberbereich 5 in den Unterbereich 6 saugbar ist. An ihrem radialen Rand weist die Leiterplatte 3 eine Vielzahl von Umfangsrandöffnungen 8 und Umfangsrandaussparungen 9 auf, die in Figur 5 noch besser zu erkennen sind. Auch diese gewährleisten eine Strömungsverbindung zwischen Ober- und Unterbereich 5, 6, so dass die über die Zentralöffnung 7 von dem Kühlrad 4 axial angesaugte Luft zunächst in radialer Richtung auswärts in Richtung des radialen Randbereichs der Leiterplatte 3 entlang der Innenwand 20 des Untergehäuses 2-2 blasbar und anschließend über die Umfangsrandöffnungen 8 und Umfangsrandaussparungen 9 in den Oberbereich 5 rückführbar ist. Dabei entsteht ein durch die Pfeile P angedeuteter Luftkühlkreislauf, bei dem die Luftströmung im Oberbereich 5 entlang der Oberfläche der Leiterplatte 3 mit den Elektronikbauteilen erfolgt und diese kühlt. Während die Luft im Unterbereich 6 an dem Untergehäuse 2-2 entlang strömt, gibt sie Wärme an das Untergehäuse 2-2 und somit mittelbar an die Umwelt nach außen ab. Die in den Oberbereich 5 rückgeführte und abgekühlte Luft kann wieder Wärme der heißen Elektronikbauteile auf der Leiterplatte 3 aufnehmen und diese dabei kühlen. Ein Luftaustausch ist aufgrund der dichten Ausführung des Elektronikgehäuses 2 nicht möglich. Das Kühlrad 4 weist eine Vielzahl von drehrichtungsorientierten gekrümmten Schaufeln 10 auf und ist an dem axialen Ende der Antriebswelle 19 des Motors befestigt bzw. aufgesetzt.

Figur 3 zeigt eine Ausführungsform gemäß der Erfindung. Figur 3 stimmt mit der Ausführung aus Figur 1 überein, jedoch ist zwischen dem Kühlrad 4 und der Leiterplatte 3 eine Berührschutzvorrichtung 15 in Form eines Gitterelements angeordnet, die eine zu der Zentralöffnung 7 axial fluchtende Öffnung 16 aufweist, so dass über das Kühlrad 4 Luft aus dem Oberbereich 5 in den Unterbereich 6 saugbar ist. An der Öffnung 16 ist eine zu dem Kühlrad 4 gerichtete Einlassdüse 17 ausgebildet ist, welche mit einem an der Nabe des Kühlrads 4 gebildeten kegelförmigen Ansaugbereich 12 strömungstechnisch zusammenwirkt und eine Düsenwirkung gewährleistet, wodurch sich die Strömungsgeschwindigkeit der Luft entlang der Pfeile P erhöht. Der kegelförmige Ansaugbereich 12 des Kühlrads 4 ragt in axialer Richtung in die Einlassdüse 17 hinein. In der gezeigten Ausführung ist die Einlassdüse 17 einteilig an der Berührschutzvorrichtung 15 ausgebildet. Zwischen der Leiterplatte 3 und dem Elektronikgehäuse 2 ist in der gezeigten Ausführung ein Luftspalt 18 vorgesehen, der eine vollständige Umströmung der Außenkante der Leiterplatte 3 gewährleistet.

Figur 4 zeigt eine weitere Ausführungsform gemäß der Erfindung, alternativ zu dem Lüfter 1 aus den Figuren 1 und 2, wobei eine Einlassdüse 14 unmittelbar an der Leiterplatte 3 als zusätzliches Bauteil eingesetzt ist. Das Kühlrad 4 weist wie in Figur 3 einen kegelförmigen Ansaugbereich 12 auf, der mit der Einlassdüse 14 zusammenwirkt. Natürlich kann auch an der Leiterplatte 3 unmittelbar eine Einlassdüse ausgebildet werden, wie dies bei der Berührschutzvorrichtung 15 gemäß Figur 3 realisiert ist.

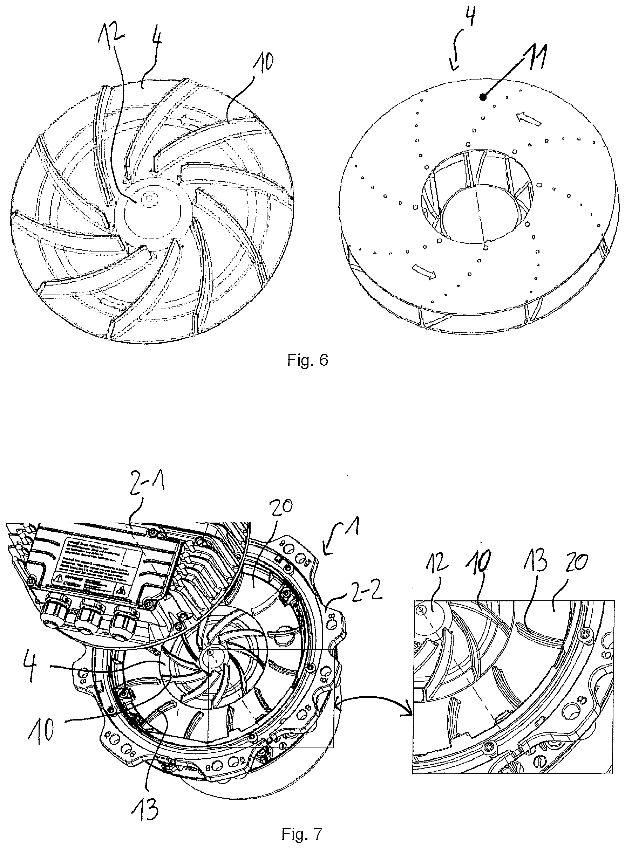

Die in Figur 5 perspektivisch dargestellte beispielhafte Leiterplatte 3 zeigt die Zentralöffnung 7 als eine große Öffnung. Alternativ können auch mehrere kleine Öffnungen im Zentralbereich als Zentralöffnung 7 zusammenwirken, solange das Kühlrad 4 Luft aus dem Oberbereich 5 in den Unterbereich 6 bei vernünftigem Wirkungsgrad saugen kann. Am radialen Rand der Leiterplatte 3 befinden sich eine Vielzahl von Umfangsrandöffnungen 8 und Umfangsrandaussparungen 9 unterschiedlicher Form und Größe, die in Abhängigkeit von der benötigten Kühlung der einzelnen Bauteile auf der Oberfläche der Leiterplatte 3 festlegbar sind. In der gezeigten Ausführung weist die Zentralöffnung eine Größe auf, die in etwa der 25-fachen Größe einer Umfangsrandöffnungen 8 entspricht. Figur 6 zeigt zwei beispielhafte Ausführungsformen von strömungsoptimierten einteiligen Kühlrädern 4 mit rückwärtsgekrümmten Schaufeln 10, wobei die auf der rechten Seite dargestellte Ausführung des Kühlrads 4 zusätzlich eine Deckscheibe 11 aufweist. Der kegelförmige Ansaugbereich gemäß der Erfindung ist in dieser Figur nicht erkennbar. Das auf der linken Seite gezeigte Kühlrad 4 ist in der perspektivischen Ansicht der Figur 7 in den Lüfter 1 eingesetzt, wobei das Deckelgehäuse 2-1 zur besseren Veranschaulichung abgehoben dargestellt ist. In der vergrößerten Ansicht der Figur 7 sind an der Innenwand 20 des Untergehäuses 2-2 stoffschlüssig ausgebildete Kühlrippen 13 zu erkennen, an denen die in radialer Richtung von dem Kühlrad 4 ausgeblasene Luft entlang strömt und Wärme an das Untergehäuse 2-2 des Elektronikgehäuses 2 abgibt. Die Kühlrippen 13 erstrecken sich in radialer Richtung bogenförmig gekrümmt, wobei die Krümmung der Kühlrippen 13 entgegen gerichtet ist zu einer Krümmung der Schaufeln 10 des Kühlrads 4, so dass die Schaufeln 10 und Kühlrippen 13 in einer Draufsicht gesehen zusammen eine inverse S-Form bilden. Alternativ können die Schaufeln und Kühlrippen auch umgedreht gebogen sein und in einer Draufsicht eine S-Form bilden. Die Leiterplatte 3 ist aus Übersichtlichkeitsgründen nicht dargestellt.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht. Beispielsweise kann auch das Kühlrad gemäß Figur 1 mit einem Kühlrad gemäß Figur 3 ausgestattet sein.

## Patentansprüche

1. Lüfter mit
einem dicht geschlossenen Elektronikgehäuse (2), in dem eine Leiterplatte (3) mit Elektronikbauteilen angeordnet ist und das Elektronikgehäuse (2) in einen Oberbereich (5) und einen Unterbereich (6) unterteilt, und
einem in dem Unterbereich (6) axial zur Leiterplatte (3) angrenzend angeordneten Kühlrad (4),
wobei die Leiterplatte (3) zur Strömungsverbindung des Oberbereichs (5) und Unterbereichs (6) mindestens eine Zentralöffnung (7) und eine Vielzahl von Umfangsrandöffnungen oder Umfangsrandaussparungen aufweist,
und durch das Kühlrad (4) Luft über die mindestens eine Zentralöffnung (7) aus dem Oberbereich (5) in den Unterbereich saugbar und über die Vielzahl von Umfangsrandöffnungen (8) oder Umfangsrandaussparungen (9) in den Oberbereich (5) rückführbar ist, wobei ein Luftkreislauf mit zumindest einer Luftströmung entlang einer Oberfläche der Leiterplatte (3) entsteht, auf der die Elektronikbauteile angeordnet sind, wobei
das Kühlrad (4) einen kegelförmigen Ansaugbereich (12) aufweist, der axial in eine Einlassdüse (14, 17), die an der Leiterplatte (3) oder einer zwischen dem Kühlrad (4) und der Leiterplatte (3) angeordneten Berührschutzvorrichtung (15) angeordnet oder ausgebildet ist, hineinragt.

2. Lüfter nach Anspruch 1 mit einer zwischen dem Kühlrad (4) und der Leiterplatte (3) angeordneten Berührschutzvorrichtung, **dadurch gekennzeichnet, dass** die Berührschutzvorrichtung (15) eine zu der mindestens einen Zentralöffnung (7) axial fluchtende Öffnung (16) aufweist, wobei an der Öffnung (16) die zu dem Kühlrad (4) gerichtete Einlassdüse (17) angeordnet ist.

3. Lüfter nach Anspruch 1, **dadurch gekennzeichnet, dass** an der mindestens einen Zentralöffnung (7) der Leiterplatte (3) die zum Kühlrad (4) gerichtete Einlassdüse (14) ausgebildet oder angeordnet ist.

4. Lüfter nach zumindest einem der vorigen Ansprüche, **dadurch gekennzeichnet, dass** das Kühlrad (4) drehrichtungsorientierte gekrümmte Schaufeln (10) und/oder eine Deckscheibe (11) aufweist.

5. Lüfter nach zumindest einem der vorigen Ansprüche, **dadurch gekennzeichnet, dass** über das Kühlrad (4) Luft in axialer Richtung ansaugt und in radialer Richtung entlang einer Innenwand (20) des Elektronikgehäuses (2) ausblasbar ist, wobei an der Innenwand (20) des Elektronikgehäuses (2) stoffschlüssig Kühlrippen (13) ausgebildet sind, an denen die in radialer Richtung ausgeblasene Luft entlang strömbar und dabei Wärme über das Elektronikgehäuse (2) abgebbar ist.

6. Lüfter nach dem vorigen Anspruch, **dadurch gekennzeichnet, dass** sich die Kühlrippen (13) in radialer Richtung mit einer Krümmung erstrecken.

7. Lüfter nach dem vorigen Anspruch, **dadurch gekennzeichnet, dass** die Krümmung der Kühlrippen (13) entgegen gerichtet ist zu einer Krümmung der Schaufeln (10) des Kühlrads (4), so dass die Schaufeln (10) und Kühlrippen (13) in einer Draufsicht eine S-Form oder inverse S-Form bilden.

8. Lüfter nach zumindest einem der vorigen Ansprüchen, **dadurch gekennzeichnet, dass** zwischen dem Elektronikgehäuse (2) und einem radialen Rand der Leiterplatte (3) ein Luftspalt (18) vorgesehen wird.

9. Lüfter nach zumindest einem der vorigen Ansprüchen, **dadurch gekennzeichnet, dass** eine Fläche der mindestens einen Zentralöffnung (7) um das 5- bis 50-fache größer ist als eine Fläche einer Umfangsrandöffnung (8) oder einer Umfangsrandaussparung (9).

10. Lüfter nach zumindest einem der vorigen Ansprüchen 1 bis 8, **dadurch gekennzeichnet, dass** eine Vielzahl von Zentralöffnungen (7) vorgesehen sind, die jeweils eine Fläche aufweisen, die einer Fläche einer Umfangsrandöffnung (8) oder Umfangsrandaussparung (9) entspricht.

11. Lüfter nach zumindest einem der vorigen Ansprüchen, **dadurch gekennzeichnet, dass** er eine über einen Motor antreibbare Antriebswelle (19) mit daran angeordneten Lüfterrad aufweist, und das Kühlrad (4) auf der Antriebswelle (19) befestigt ist.

12. Verfahren zur Kühlung von auf einer Leiterplatte (3) eines Lüfters (1) angeordneten Elektronikbauteilen, wobei die Leiterplatte (3) in einem luftdicht geschlossenen Elektronikgehäuse (2) des Lüfters (1) befestigt ist und das Elektronikgehäuse (2) in einen Oberbereich (5) und einen Unterbereich (6) unterteilt, wobei die Leiterplatte (3) zur Strömungsverbindung des Oberbereichs (5) und Unterbereichs (6) mindestens eine Zentralöffnung (7) und eine Vielzahl von Umfangsrandöffnungen (8) und/oder Umfangsrandaussparungen (9) aufweist, und durch ein Kühlrad (4) Luft über die mindestens eine Zentralöffnung (7) aus dem Oberbereich (5) in den Unterbereich gesaugt und über die Vielzahl von Umfangsrandöffnungen (8) und/oder Umfangsrandaussparungen (9) in den Oberbereich (5) zurückgeführt wird, wobei das Kühlrad (4) einen kegelförmigen Ansaugbereich (12) aufweist, der axial in eine Einlassdüse (14, 17), die an der Leiterplatte (3) oder einer zwischen dem Kühlrad (4) und der Leiterplatte (3) angeordneten Berührschutzvorrichtung (15) angeordnet oder ausgebildet ist, hineinragt, und wobei ein Luftkreislauf mit zumindest einer Luftströmung entlang einer Oberfläche der Leiterplatte (3), auf der die Elektronikbauteile angeordnet sind, erzeugt wird.

13. Verfahren nach Anspruch 12, **dadurch gekennzeichnet, dass** das Kühlrad (4) drehrichtungsorientierte gekrümmte Schaufeln (10) aufweist und Luft in axialer Richtung ansaugt und in radialer Richtung entlang einer Innenwand des Elektronikgehäuses (2) ausbläst, wobei an der Innenwand (20) des Elektronikgehäuses (2) stoffschlüssig Kühlrippen (13) ausgebildet sind, gegen die von dem Kühlrad (4) ausgeblasene Luft geblasen wird, so dass Wärme aus der Luft an das Elektronikgehäuse (2) abgegeben wird.

## Claims

1. Fan comprising a tightly sealed electronics housing (2), in which a printed circuit board (3) comprising electronic components is arranged, and the electronics housing (2) is divided into an upper region (5) and a lower region (6), and
a cooling wheel (4) which is arranged in the lower region (6) so as to be axially adjacent to the printed circuit board (3),
wherein the printed circuit board (3) comprises at least one central opening (7) and a plurality of peripheral-edge openings or peripheral-edge gaps in order to bring the upper region (5) into fluid communication with the lower region (6), and, by means of the cooling wheel (4), air can be drawn out of the upper region (5) into the lower region via the at least one central opening (7) and, via the plurality of peripheral-edge openings (8) or peripheral-edge gaps (9), can be fed back into the upper region (5), wherein an air circuit having at least one air flow develops along a surface of the printed circuit board (3) on which the electronic components are arranged, wherein
the cooling wheel (4) comprises a conical suction region (12) which projects axially into the inlet nozzle (14, 17) which is arranged or formed on the printed circuit board (3) or on a contact-protection device (15) arranged between the cooling wheel (4) and the printed circuit board (3).

2. Fan according to claim 1 having a contact-protection device (15) arranged between the cooling wheel (4) and the printed circuit board (3), **characterized in that** the contact-protection device (15) comprises an opening (16) which is axially flush with the at least one central opening (7), wherein an inlet nozzle (17) which is directed towards the cooling wheel (4) being arranged on the opening (16).

3. Fan according to claim 1, **characterized in that** the inlet nozzle (14) which is directed towards the cooling wheel (4) is formed or arranged on the at least one central opening (7) of the printed circuit board (3).

4. Fan according to at least one of the preceding claims, **characterized in that** the cooling wheel (4) comprises curved blades (10) which are oriented in the rotational direction and/or a cover disc (11).

5. Fan according to at least one of the preceding claims, **characterized in that** air is sucked in in the axial direction via the cooling wheel (4) and can be blown out in the radial direction along an inner wall (20) of the electronics housing (2), wherein cooling ribs (13) being formed on the inner wall (20) of the electronics housing (2) in an integrally bonded manner, along which ribs the air which is blown out in the radial direction can flow, and heat can be emitted via the electronics housing (2).

6. Fan according to the preceding claim, **characterized in that** the cooling ribs (13) extend in the radial direction with curvature.

7. Fan according to the preceding claim, **characterized in that** the curvature of the cooling ribs (13) is counter to a curvature of the blades (10) of the cooling wheel (4), so that the blades (10) and the cooling ribs (13) form an S shape or inverted S shape in plan view.

8. Fan according to at least one of the preceding claims, **characterized in that** a ventilation slot (18) is provided between the electronics housing (2) and a radial edge of the printed circuit board (3).

9. Fan according to at least one of the preceding claims, **characterized in that** a surface area of the at least one central opening (7) is 5 to 50 times greater than a surface area of a peripheral-edge opening (8) or a peripheral-edge gap (9).

10. Fan according to at least one of the preceding claims 1 to 8, **characterized in that** a plurality of central openings (7) are provided which each have a surface area which corresponds to a surface area of a peripheral-edge opening (8) or a peripheral-edge gap (9).

11. Fan according to at least one of the preceding claims, **characterized in that** said fan comprises a drive shaft (19) which can be driven by a motor and has a fan wheel arranged thereon, and the cooling wheel (4) is fastened to the drive shaft (19).

12. Method for cooling electronic components arranged on a printed circuit board (3) of a fan (1), wherein the printed circuit board (3) is fastened in an electronics housing (2) of the fan (1) which is closed in an airtight manner and the electronics housing (2) is divided into an upper region (5) and a lower region (6), wherein the printed circuit board (3) comprises at least one central opening (7) and a plurality of peripheral-edge openings (8) and/or peripheral-edge gaps (9) in order to bring the upper region (5) into fluid communication with the lower region (6), and, by means of the cooling wheel (4), air can be drawn out of the upper region (5) into the lower region via the at least one central opening (7) and, via the plurality of peripheral-edge openings (8) and/or peripheral-edge gaps (9), can be fed back into the upper region (5), wherein the cooling wheel (4) comprises a conical suction region (12) which projects axially into the inlet nozzle (14, 17) which is arranged or formed on the printed circuit board (3) or on a contact-protection device (15) arranged between the cooling wheel (4) and the printed circuit board (3) and wherein an air circuit having at least one air flow is generated along a surface of the printed circuit board (3) on which the electronic components are arranged.

13. Method according to claim 12, **characterized in that** the cooling wheel (4) comprises curved blades (10) which are oriented in the rotational direction and sucks in air in the axial direction and blows out air in the radial direction along an inner wall of the electronics housing (2), wherein cooling ribs (13) being formed on the inner wall (20) of the electronics housing (2) in an integrally bonded manner, against which ribs air blown out by the cooling wheel (4) is blown, so that heat from the air can be emitted at the electronics housing (2).

## Revendications

1. Ventilateur avec
un boîtier électronique (2) fermé de manière étanche, dans lequel un circuit imprimé (3) avec des composants électroniques est agencé et subdivise le boîtier électronique (2) en une zone supérieure (5) et une zone inférieure (6), et
une roue de refroidissement (4) agencée de manière adjacente dans la zone inférieure (6) axialement au circuit imprimé (3),
dans lequel le circuit imprimé (3) présente pour la liaison fluidique de la zone supérieure (5) et de la zone inférieure (6) au moins une ouverture centrale (7) et une pluralité d'ouvertures de bord périphérique ou d'évidements de bord périphérique,
et par la roue de refroidissement (4) l'air peut être aspiré via l'au moins une ouverture centrale (7) de la zone supérieure (5) à la zone inférieure et peut être ramené via la pluralité d'ouvertures de bord périphérique (8) ou d'évidements de bord périphérique (9) dans la zone supérieure (5), dans lequel un circuit d'air avec au moins un écoulement d'air le long d'une surface du circuit imprimé (3) est créé, sur lequel les composants électroniques sont agencés, dans lequel la roue de refroidissement (4) présente une zone d'aspiration (12) conique, qui pénètre axialement dans une buse d'entrée (14, 17), qui est agencée ou réalisée au niveau du circuit imprimé (3) ou d'un dispositif de protection contre les contacts (15) agencé entre la roue de refroidissement (4) et le circuit imprimé (3).

2. Ventilateur selon la revendication 1 avec un dispositif de protection contre les contacts agencé entre la roue de refroidissement (4) et le circuit imprimé (3), **caractérisé en ce que** le dispositif de protection contre les contacts (15) présente une ouverture (16) alignée axialement avec l'au moins une ouverture centrale (7), dans lequel la buse d'entrée (17) dirigée vers la roue de refroidissement (4) est agencée au niveau de l'ouverture (16).

3. Ventilateur selon la revendication 1, **caractérisé en ce que** la buse d'entrée (14) dirigée vers la roue de refroidissement (4) est réalisée ou agencée au niveau de l'au moins une ouverture centrale (7) du circuit imprimé (3).

4. Ventilateur selon au moins l'une quelconque des revendications précédentes, **caractérisé en ce que** la roue de refroidissement (4) présente des pales (10) incurvées orientées dans le sens de rotation et/ou un disque de recouvrement (11).

5. Ventilateur selon au moins l'une quelconque des revendications précédentes, **caractérisé en ce que** l'air aspire dans la direction axiale par le biais de la roue de refroidissement (4) et peut être soufflé dans la direction radiale le long d'une paroi intérieure (20) du boîtier électronique (2), dans lequel des nervures de refroidissement (13) sont réalisées par complémentarité de matière au niveau de la paroi intérieure (20) du boîtier électronique (2), le long desquelles l'air soufflé dans la direction radiale peut s'écouler et ce faisant de la chaleur peut être dégagée par le biais du boîtier électronique (2).

6. Ventilateur selon la revendication précédente, **caractérisé en ce que** les nervures de refroidissement (13) s'étendent dans la direction radiale avec une courbure.

7. Ventilateur selon la revendication précédente, **caractérisé en ce que** la courbure des nervures de refroidissement (13) est dirigée dans le sens opposé à une courbure des pales (10) de la roue de refroidissement (4), de sorte que les pales (10) et les nervures de refroidissement (13) forment dans une vue de dessus une forme de S ou une forme de S inverse.

8. Ventilateur selon au moins l'une quelconque des revendications précédentes, **caractérisé en ce qu'**un espace d'air (18) est prévu entre le boîtier électronique (2) et un bord radial du circuit imprimé (3).

9. Ventilateur selon au moins l'une quelconque des revendications précédentes, **caractérisé en ce qu'**une surface de l'au moins une ouverture centrale (7) est 5 à 50 fois plus grande qu'une surface d'une ouverture de bord périphérique (8) ou d'un évidement de bord périphérique (9).

10. Ventilateur selon au moins l'une quelconque des revendications précédentes 1 à 8, **caractérisé en ce qu'**une pluralité d'ouvertures centrales (7) est prévue, qui présentent respectivement une surface, qui correspond à une surface d'une ouverture de bord périphérique (8) ou d'un évidement de bord périphérique (9).

11. Ventilateur selon au moins l'une quelconque des revendications précédentes, **caractérisé en ce qu'**il présente un arbre d'entraînement (19) pouvant être entraîné par le biais d'un moteur avec roue de ventilateur qui y est agencée, et la roue de refroidissement (4) est fixée sur l'arbre d'entraînement (19).

12. Procédé de refroidissement de composants électroniques agencés sur un circuit imprimé (3) d'un ventilateur (1), dans lequel le circuit imprimé (3) est fixé dans un boîtier électronique (2) fermé de manière étanche à l'air du ventilateur (1) et subdivise le boîtier électronique (2) en une zone supérieure (5) et une zone inférieure (6), dans lequel le circuit imprimé (3) présente pour la liaison fluidique de la zone supérieure (5) et de la zone inférieure (6) au moins une ouverture centrale (7) et une pluralité d'ouvertures de bord périphérique (8) et/ou d'évidements de bord périphérique (9), et par une roue de refroidissement (4) l'air est aspiré via l'au moins une ouverture centrale (7) de la zone supérieure (5) à la zone inférieure et ramené via la pluralité d'ouvertures de bord périphérique (8) et/ou d'évidements de bord périphérique (9) dans la zone supérieure (5), dans lequel la roue de refroidissement (4) présente une zone d'aspiration (12) conique, qui pénètre axialement dans une buse d'entrée (14, 17), qui est agencée ou réalisée au niveau du circuit imprimé (3) ou d'un dispositif de protection contre les contacts (15) agencé entre la roue de refroidissement (4) et le circuit imprimé (3), et dans lequel un circuit d'air avec au moins un écoulement d'air le long d'une surface du circuit imprimé (3) est généré, sur lequel les composants électroniques sont agencés.

13. Procédé selon la revendication 12, **caractérisé en ce que** la roue de refroidissement (4) présente des pales (10) incurvées orientées dans le sens de rotation et aspire l'air dans la direction axiale et le souffle dans la direction radiale le long d'une paroi intérieure du boîtier électronique (2), dans lequel des nervures de refroidissement (13) sont réalisées par complémentarité de matière au niveau de la paroi intérieure (20) du boîtier électronique (2), contre lesquelles l'air soufflé par la roue de refroidissement (4) est soufflé de sorte que de la chaleur est dégagée de l'air au boîtier électronique (2).
